# EUROPEAN PATENT APPLICATION

(11) **EP 4 016 598 A1**
(43) Date of publication of application: **22.06.2022**
(21) Application number: 21195439.1
(22) Date of filing: 08.09.2021
(51) Int. Cl.: H01L 21/768, H01L 23/522

(54) **GUIDED VIAS IN MICROELECTRONIC STRUCTURES**

(30) Priority: 17.12.2020 US 202017125232
(71) Applicant: INTEL Corporation, Santa Clara, CA 95054 (US)
(72) Inventor: Singh, Gurpreet, Portland, 97229 (US); Han, Eungnak, Portland, 97229 (US); Chen, Xuanxuan, Hillsboro, 97124 (US); Mahdi, Tayseer, Beaverton, 97006 (US); Krysak, Marie, Portland, 97225 (US); Holybee, Brandon Jay, Portland, 97203 (US); Gstrein, Florian, Portland, 97212 (US)
(74) Representative: Goddar, Heinz J.

(57) **Abstract**

Disclosed herein are guided vias in microelectronic structures. For example, a microelectronic structure may include a metallization layer including a conductive via in contact with a conductive line, wherein a center of a top surface of the conductive via is laterally offset from a center of a bottom surface of the conductive via.

## Description

### Background

Conventional microelectronic fabrication techniques may not be able to reliably pattern particularly small features. Consequently, the size and performance of microelectronic devices has been limited.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIGS. 1A-1B are various views of a microelectronic structure including guided vias, in accordance with various embodiments.
FIGS. 2A-2B, 3A-3B, 4A-4B, 5A-5B, 6A-6B, and 7A-7B illustrate stages in an example process for manufacturing the microelectronic structure of FIG. 1.
FIGS. 8A-8B are various views of another microelectronic structure including guided vias, in accordance with various embodiments.
FIG. 9 is a top view of a wafer and dies that may include any of the microelectronic structures disclosed herein.
FIG. 10 is a side, cross-sectional view of a microelectronic device that may include any of the microelectronic structures disclosed herein.
FIG. 11 is a side, cross-sectional view of a microelectronic package that may include any of the microelectronic structures disclosed herein.
FIG. 12 is a side, cross-sectional view of a microelectronic device assembly that may include any of the microelectronic structures disclosed herein.
FIG. 13 is a block diagram of an example computing device that may include any of the microelectronic structures disclosed herein.

### Detailed Description

Disclosed herein are guided vias in microelectronic structures. For example, a microelectronic structure may include a metallization layer including a conductive via in contact with a conductive line, wherein a center of a top surface of the conductive via is laterally offset from a center of a bottom surface of the conductive via.

Existing conventional lithography techniques, such as existing conventional extreme ultraviolet (EUV) techniques, may not be able to pattern features that are both sufficiently small and have sufficiently few defects to be used in commercial microelectronic devices. For example, conventional EUV lithography may sufferfrom high roughness and excessive bridging defects at tight pitches (e.g., pitches below 32 nanometers), which may limit or effectively prevent deployment of EUV patterning techniques (e.g., spacer-based pitch-division techniques having resist "backbones" defined by EUV lithography). Conventional EUV lithographic techniques also sufferfrom a trade-off between EUV dose and resist thickness; although higher EUV doses have the potential to pattern lines with lower roughnesses, such higher EUV doses typically require thinner resist layers in order to achieve a desired depth of focus and avoid pattern collapse, but these thinner resist layers typically cannot withstand etch transfer (i.e., the transfer of a pattern in the resist to one or more underlying layers) as well as thicker resists can. These constraints have provided significant barriers to the adoption of EUV techniques in commercial microelectronic fabrication processes.

Various ones of the embodiments disclosed herein may remedy the deficiencies of conventional EUV lithographic techniques through the use of fabrication techniques that include directed self-assembly (DSA) operations. DSA-based techniques may utilize the propensity of some materials to self-organize into particular patterns under certain conditions, and these patterns may be utilized in various ways to fabricate small and accurate features in a microelectronic device.

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made, without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The phrase "A, B, or C" means (A), (B), (C), (A and B), (A and C), (B and C), or (A, B, and C). The drawings are not necessarily to scale. Although many of the drawings illustrate rectilinear structures with flat walls and right-angle corners, this is simply for ease of illustration, and actual devices made using these techniques will exhibit rounded corners, surface roughness, and other features.

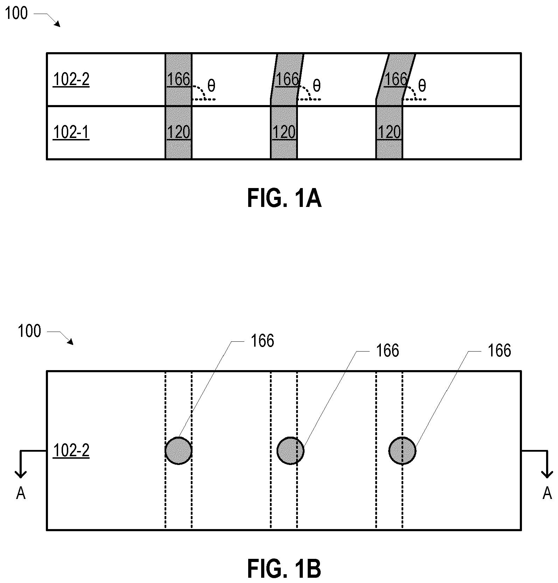

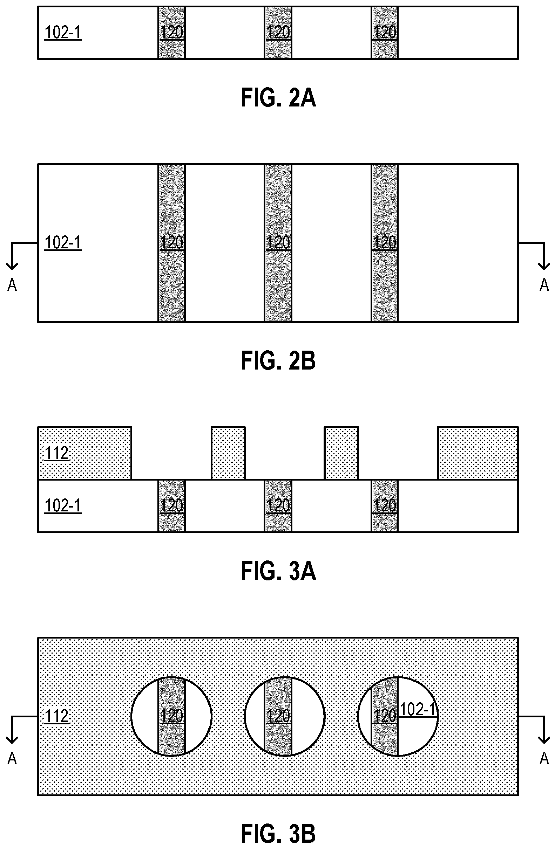

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. As used herein, a "conductive" material refers to an electrically conductive material, unless otherwise specified. When used to describe a range of dimensions, the phrase "between X and Y" represents a range that includes X and Y. For convenience, the phrase "FIG. 1" may be used to refer to the collection of drawings of FIGS. 1A-1B, the phrase "FIG. 2" may be used to refer to the collection of drawings of FIGS. 2A-2B, etc.

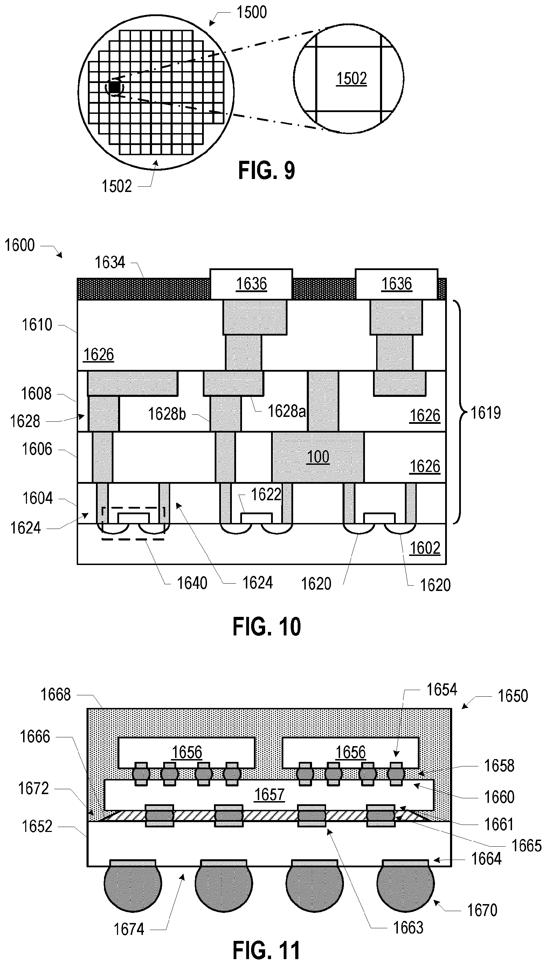

FIGS. 1A-1B are various views of an example microelectronic structure 100 including guided vias 166. The guided vias 166 may extend through an upper dielectric layer 102-2 to contact a conductive structure 120 (e.g., a conductive line) in a lower dielectric layer 102-1. FIG. 1A is a side, cross-sectional view of the microelectronic structure 100 through the section A-A of FIG. 1B, and FIG. 1B is a top view of the microelectronic structure 100. The footprints of the conductive structures 120 of the microelectronic structure 100 of FIG. 1A are shown in dotted lines in FIG. 1B. In some embodiments, the microelectronic structure 100 of FIG. 1 may be part of a metallization layer in a microelectronic device (e.g., as discussed below with reference to FIG. 10).

One or more of the guided vias 166 in a microelectronic structure 100 may be oriented at an angle θ that is between 40 degrees and 90 degrees (e.g., between 40 degrees and 45 degrees, between 40 degrees and 50 degrees, between 40 degrees and 55 degrees, between 40 degrees and 60 degrees, between 40 degrees and 65 degrees, between 40 degrees and 70 degrees, between 40 degrees and 75 degrees, between 40 degrees and 80 degrees, or between 40 degrees and 85 degrees). In the particular illustration of FIG. 1, the leftmost guided via 166 may be oriented at an angle θ that is equal to 90 degrees (i.e., the leftmost guided via 166 has a longitudinal axis that is perpendicular to a plane of the conductive structures 120 and/or perpendicular to a plane of the lower dielectric layer 102-1 and/or perpendicular to a plane of the upper dielectric layer 102-2). In the particular illustration of FIG. 1, the middle guided via 166 may be oriented at an angle θ that is less than 90 degrees (i.e., the middle guided via 166 has a longitudinal axis that is not perpendicular to a plane of the conductive structures 120 and/or not perpendicular to a plane of the lower dielectric layer 102-1 and/or not perpendicular to a plane of the upper dielectric layer 102-2). In the particular illustration of FIG. 1, the rightmost guided via 166 may be oriented at an angle θ that is less than 90 degrees (and less than the angle θ of the middle guided via 166) (i.e., the rightmost guided via 166 has a longitudinal axis that is not perpendicular to a plane of the conductive structures 120 and/or not perpendicular to a plane of the lower dielectric layer 102-1 and/or not perpendicular to a plane of the upper dielectric layer 102-2). Different ones of the guided vias 166 in a microelectronic structure 100 may have the same or different angle θ (e.g., different ones of the guided vias 166 in a single layer of the dielectric layer 102).

The guided vias 166 may not have straight sidewalls, but may have some curvature to their sidewalls, resulting in the angled orientation of one or more of the guided vias 166. In some embodiments, as illustrated in FIG. 1, a non-perpendicular guided via 166 (i.e., the middle and rightmost guided vias 166) may have a top surface having a center that is laterally offset from a center of the bottom surface of the guided via 166, with the bottom surface of the guided via 166 in contact with the top surface of the associated conductive structure 120. In some embodiments, as illustrated in FIG. 1, a non-perpendicular guided via 166 (i.e., the middle and rightmost guided vias 166) may have a top surface having a center that is laterally offset from a center of the top surface of the associated conductive structure 120 (i.e., as illustrated in FIG. 1B), with the bottom surface of the guided via 166 in contact with the top surface of the associated conductive structure 120. In some embodiments, a center of the bottom surface of a guided via 166 may be aligned with a center of the top surface of the associated conductive structure 120. In some embodiments, sidewalls of the bottom surface of a guided via 166 may be aligned with sidewalls of the top surface of the associated conductive structure 120 (e.g., the bottom surface of a guided via 166 may be "self-aligned" with the top surface of the conductive structure 120 on which it lands). Although FIG. 1 illustrates the guided vias 166 as having circular cross-sections when viewed from the top, this is simply an example, and in other embodiments, the guided vias 166 may have other cross-sectional shapes (e.g., an oval, as discussed below with reference to FIG. 9).

The conductive structures 120 may include any suitable materials. The conductive structures 120 may include one or more layers of various materials, such as one or more layers of liner material and fill material. In some embodiments, a liner material may include tantalum, tantalum nitride, titanium, titanium nitride, cobalt, or ruthenium (e.g., combinations thereof) and a fill material may include tungsten, cobalt (e.g., as cobalt silicide), ruthenium, molybdenum, copper, silver, nickel (e.g., as nickel silicide), gold, aluminum, other metals or alloys, or other combinations of materials.

The lower dielectric layer 102-1 and the upper dielectric layer 102-2 may include any suitable dielectric materials, and may have the same or different material compositions. Moreover, the lower dielectric layer 102-1 and/or the upper dielectric layer 102-2 may include one or more layers or other arrangements of different dielectric materials (e.g., the upper dielectric layer 102-2 may include one or more particular dielectric materials at the interface between the upper dielectric layer 102-2 and the lower dielectric layer 102-1, and a different dielectric material for the remainder of the upper dielectric layer 102-2). For example, in some embodiments, a dielectric layer 102 may include an inorganic dielectric material, such as silicon oxide, carbon-doped oxide, silicon nitride, silicon carbide, silicon oxynitride, silicon oxycarbide, or insulating metal oxides such as hafnium oxide and zirconium oxide.

FIGS. 2-8 illustrate stages in an example process of manufacturing the microelectronic structure 100 of FIG. 1, in accordance with various embodiments. Although the operations of the method of FIGS. 2-8 may be illustrated with reference to particular embodiments of the microelectronic structures 100 disclosed herein, the method of FIGS. 2-8 may be used to form any suitable microelectronic structures 100. Operations are illustrated once each and in a particular order in FIGS. 2-8, but the operations may be reordered and/or repeated as suitable (e.g., with different operations performed in parallel when manufacturing multiple microelectronic structures 100 simultaneously). In FIGS. 2-8, the "A" subfigures are side, cross-sectional views taken through the sections A-A of the "B" subfigures, while the "B" subfigures are top views.

FIG. 2 illustrates an assembly including a lower dielectric layer 102-1 having conductive structures 120 therein. As noted above, in some embodiments, the conductive structures 120 may be conductive lines, but the conductive structures 120 may include any suitable conductive structures (e.g., transistor gate contacts or transistor source/drain contacts, as discussed below with reference to FIG. 10). The lower dielectric layer 102-1 may be part of a device layer or part of a metallization layer (e.g., as discussed below with reference to FIG. 10).

FIG. 3 illustrates an assembly subsequent to depositing and patterning a resist material 112 on the assembly of FIG. 2. The resist material 112 may include any suitable resist material (e.g., a photoresist) and may be deposited on the assembly of FIG. 2 in any desired manner (e.g., spin-coating). The resist material 112 may be patterned (e.g., using a lithographic technique, such as EUV) to create openings to expose the underlying lower dielectric layer 102-1 and conductive structures 120. As shown, the openings may be wider than the conductive structures 120 themselves, and due to the constraints on the achievable accuracy of lithography, may not be centered on the conductive structures 120 (e.g., as illustrated for the middle and rightmost conductive structures 120). Consequently, if vias were formed at the center of the openings in the resist material 112, as would be done using some existing processes, the vias would be offset from the conductive structures 120 and thus may have limited contact area with the conductive structures 120 or may "miss" the conductive structures 120 entirely.

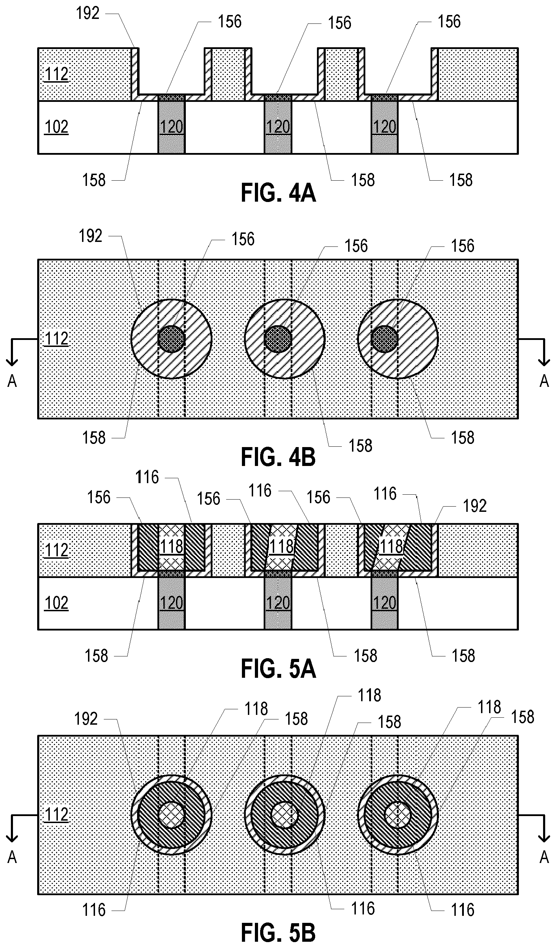

FIG. 4 illustrates an assembly subsequent to forming a replication brush 192 on the assembly of FIG. 3. The replication brush 192 may include a material that will serve as a template for DSA of a block copolymer (BCP), as described below. The replication brush 192 may include a first replication brush component 156 and a second replication brush component 158. The first replication brush component 156 may preferentially attach to the conductive structures 120 and the second replication brush component 158 may preferentially attach to the lower dielectric layer 102-2 and the resist material 112 to form a self-assembled replication brush 192. In some embodiments, the first replication brush component 156 (a metal-selective brush material) may have a surface anchoring group including phosphines, thiol, thiolate, thioacetate, disulfide, alkyl azide, aryl azide, nitrile, phosphate, silyl, alkyl and other phosphonate ester, phosphonamide, sulfonamides, sulfenate, sulfinate, sulfonate, boronic acid, phosphonic acids, carboxylic acids, phosphorous dichloride, alkenes or alkyne material. In some embodiments, the second replication brush component 158 (a dielectric-selective brush material) may have a surface anchoring group of hydroxyl, amines, or a carboxylic acid group. As used herein, a "brush" may refer to any material that facilitates the self-assembly of a DSA material thereon, and may include large polymers, small polymers, self-assembled monolayers (SAMs), and other suitable materials. The replication brush 192 may be conformal over the assembly of FIG. 3, as shown.

FIG. 5 illustrates an assembly subsequent to depositing a BCP on the assembly of FIG. 4, and treating the resulting assembly to cause the BCP to self-assemble into a first BCP component 116 and a second BCP component 118 in accordance with the template provided by the replication brush 192. In the particular embodiment of FIG. 5, the self-assembly of the BCP includes the BCP self-segregating its first BCP component 116 and second BCP component 118 into concentric bands in the openings in the resist material 112. A BCP may be able to "stretch" or "shrink" around a nominal "inherent" spacing of the self-assembled bands of the first BCP component 116/second BCP component 118, allowing a range of dimensions of the self-assembled bands of the first BCP component 116/second BCP component 118, as well as some tolerance to deviation. The self-assembly of the first BCP component 116 and the second BCP component 118 may be guided by the openings in the resist material 112 as well as the underlying replication brush 192, and thus may result in a first BCP component 116 that is angled between the plane of the top surface of the resist material 112 and the plane of the bottom surface of the resist material 112 when the openings in the resist material 112 are laterally offset from the conductive structures 120; these angles may take the form of the angles of the guided vias 166 as discussed above. A BCP may include any suitable number of components, and may take any suitable form. One example of a BCP that may serve as the BCP in the operations disclosed herein is polystyrene-co-poly(methyl methacrylate) (PS-PMMA); when the BCP is PS-PMMA, the first BCP component 116 may be polystyrene (PS) while the second BCP component 118 may be poly(methyl methacrylate) (PMMA).

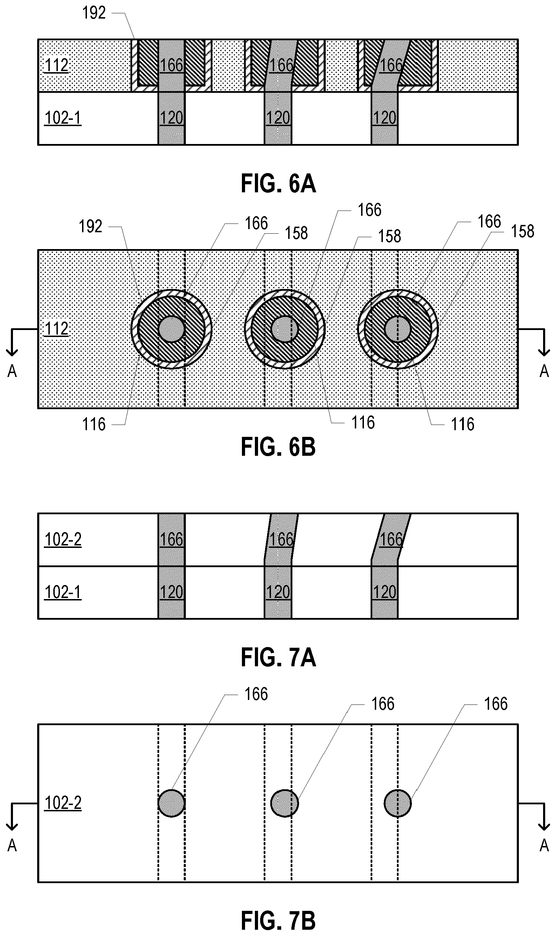

FIG. 6 illustrates an assembly subsequent to replacing the second BCP component 118 and the first replication brush component 156 of the assembly of FIG. 5 with conductive material (and other material, as suitable) to form the guided vias 166. The guided vias 166 thus may land on the conductive structures 120 (e.g., due to the preferential attachment of the first replication brush component 156 to the conductive structures 120) and may be angled from their bottom surfaces to their top surfaces (e.g., due to the angling of the second BCP component 118 between the chemoepitaxial forces provided by the replication brush 192 and the graphoepitaxial forces of the offset opening in the resist material 112). The second BCP component 118 and the first replication brush component 156 of the assembly of FIG. 5 may be removed by any suitable selective etch techniques, and the material of the guided vias 166 may be deposited, and the resulting assembly planarized (e.g., using a chemical mechanical planarization (CMP) technique) to yield the assembly of FIG. 6.

FIG. 7 illustrates an assembly subsequent to replacing the first BCP component 116, the second replication brush component 158, and the resist material 112 of the assembly of FIG. 6 with material of the upper dielectric layer 102-2. The first BCP component 116, the second replication brush component 158, and the resist material 112 may be removed using any suitable selective etch techniques, and the material of the upper dielectric layer 102-2 may be deposited in any suitable manner. The assembly of FIG. 7 may take the form of the microelectronic structure 100 of FIG. 1. Subsequent manufacturing operations may be performed on the assembly of FIG. 7 (e.g., additional metallization layers may be formed, as discussed further below).

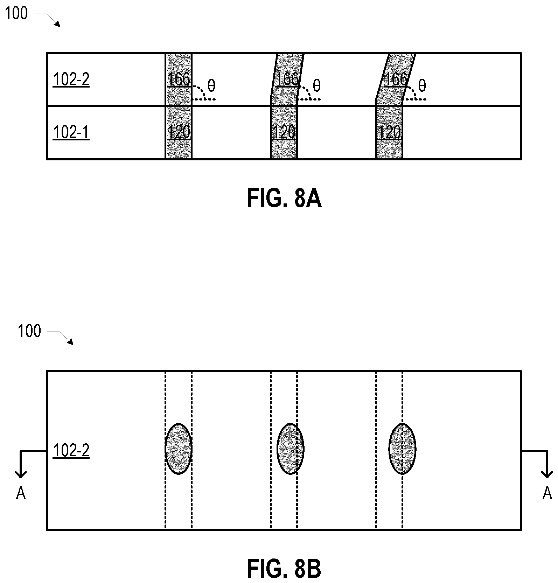

As noted above, in some embodiments, the guided vias 166 may not have a top cross-sectional shape that is circular. For example, FIG. 8 illustrates a microelectronic structure 100 like that of FIG. 1, but in which the top cross-sectional shape of the guided vias 166 is an oval (e.g., an elongated rounded shape). FIG. 8A is a side, cross-sectional view of the microelectronic structure 100 through the section A-A of FIG. 8B, and FIG. 8B is a top view of the microelectronic structure 100. The elements of the microelectronic structure 100 of FIG. 8 may take the form of any of the corresponding elements of the microelectronic structure 100 of FIG. 1. Guided vias 166 like those of FIG. 8 may be formed using an appropriate BCP whose self-assembly results in an oval cross-sectional shape of the second BCP component 118, as known in the art. More generally, a guided via 166 may have any suitable top cross-sectional shape.

The microelectronic structures 100 disclosed herein may be included in any suitable electronic component. FIGS. 9-13 illustrate various examples of apparatuses that may include any of the microelectronic structures 100 disclosed herein.

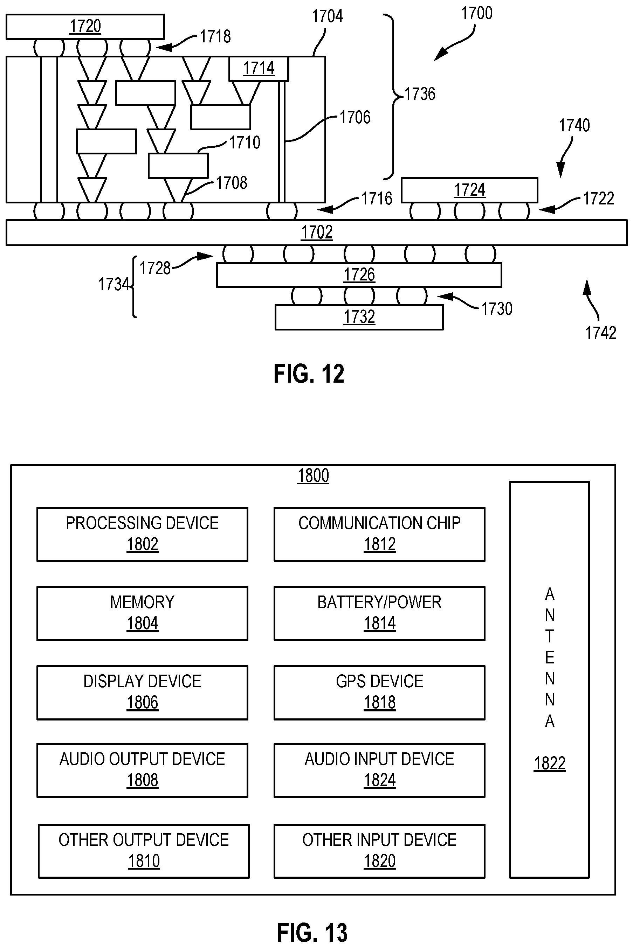

FIG. 9 is a top view of a wafer 1500 and dies 1502 that may include one or more microelectronic structures 100 in accordance with any of the embodiments disclosed herein. The wafer 1500 may be composed of semiconductor material and may include one or more dies 1502 having microelectronic structures formed on a surface of the wafer 1500. Each of the dies 1502 may be a repeating unit of a semiconductor product that includes any suitable microelectronic structure. After the fabrication of the semiconductor product is complete, the wafer 1500 may undergo a singulation process in which the dies 1502 are separated from one another to provide discrete "chips" of the semiconductor product. The die 1502 may include one or more microelectronic structures 100 (e.g., as discussed below with reference to FIG. 10), one or more transistors (e.g., some of the transistors 1640 of FIG. 10, discussed below) and/or supporting circuitry to route electrical signals to the transistors, as well as any other circuit components. In some embodiments, the wafer 1500 or the die 1502 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 13) or other logic that is configured to store information in the memory devices or execute instructions stored in the memory array.

FIG. 10 is a side, cross-sectional view of a microelectronic device 1600 that may include one or more microelectronic structures 100 in accordance with any of the embodiments disclosed herein. One or more of the microelectronic devices 1600 may be included in one or more dies 1502 (FIG. 9). The microelectronic device 1600 may be formed on a substrate 1602 (e.g., the wafer 1500 of FIG. 9) and may be included in a die (e.g., the die 1502 of FIG. 9). The substrate 1602 may be a semiconductor substrate composed of semiconductor material systems including, for example, n-type or p-type materials systems (or a combination of both). The substrate 1602 may include, for example, a crystalline substrate formed using a bulk silicon or a silicon-on-insulator (SOI) substructure. In some embodiments, the substrate 1602 may be formed using alternative materials, which may or may not be combined with silicon, that include but are not limited to germanium, indium antimonide, lead telluride, indium arsenide, indium phosphide, gallium arsenide, or gallium antimonide. Further materials classified as group II-VI, III-V, or IV may also be used to form the substrate 1602. Although a few examples of materials from which the substrate 1602 may be formed are described here, any material that may serve as a foundation for a microelectronic device 1600 may be used. The substrate 1602 may be part of a singulated die (e.g., the dies 1502 of FIG. 9) or a wafer (e.g., the wafer 1500 of FIG. 9).

The microelectronic device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control currentflow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 10 and may include a wide variety of other types and configurations such as, for example, planar transistors, non-planar transistors, or a combination of both. Planar transistors may include bipolar junction transistors (BJT), heterojunction bipolar transistors (HBT), or high-electron-mobility transistors (HEMT). Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried outon the gate dielectric to improve its quality when a high-k material is used.

The gate electrode may be formed on the gate dielectric and may include at least one p-type work function metal or n-type work function metal, depending on whether the transistor 1640 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1640 along the source-channel-drain direction, the gate electrode may consist of a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1620 may be formed within the substrate 1602 adjacent to the gate 1622 of each transistor 1640. The S/D regions 1620 may be formed using an implantation/diffusion process or an etching/deposition process, for example. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion-implantation process. In the latter process, the substrate 1602 may first be etched to form recesses at the locations of the S/D regions 1620. An epitaxial deposition process may then be carried out to fill the recesses with material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620.

Electrical signals, such as power and/or input/output (I/O) signals, may be routed to and/or from the devices (e.g., the transistors 1640) of the device layer 1604 through one or more metallization layers disposed on the device layer 1604 (illustrated in FIG. 10 as metallization layers 1606-1610). For example, conductive features of the device layer 1604 (e.g., the gate 1622 and the S/D contacts 1624) may be electrically coupled with the interconnect structures 1628 of the metallization layers 1606-1610. The one or more metallization layers 1606-1610 may form a metallization stack (also referred to as an "ILD stack") 1619 of the microelectronic device 1600. FIG. 10 illustrates a microelectronic structure 100 included in the "M0" metallization layer 1606 of the metallization stack 1619, but this is simply illustrative, and any of the microelectronic structures 100 disclosed herein may be included in any of the metallization layers of a metallization stack 1619, as desired.

The interconnect structures 1628 may be arranged within the metallization layers 1606-1610 to route electrical signals according to a wide variety of designs (in particular, the arrangement is not limited to the particular configuration of interconnect structures 1628 depicted in FIG. 10). Although a particular number of metallization layers 1606-1610 is depicted in FIG. 10, embodiments of the present disclosure include microelectronic devices having more or fewer metallization layers than depicted.

In some embodiments, the interconnect structures 1628 may include lines 1628a and/or vias 1628b filled with a conductive material such as a metal. The lines 1628a may be arranged to route electrical signals in a direction of a plane that is substantially parallel with a surface of the substrate 1602 upon which the device layer 1604 is formed. For example, the lines 1628a may route electrical signals in a direction in and out of the page from the perspective of FIG. 10. The vias 1628b may be arranged to route electrical signals in a direction of a plane that is substantially perpendicular to the surface of the substrate 1602 upon which the device layer 1604 is formed. In some embodiments, the vias 1628b may electrically couple lines 1628a of different metallization layers 1606-1610 together.

The metallization layers 1606-1610 may include a dielectric material 1626 disposed between the interconnect structures 1628, as shown in FIG. 10. In some embodiments, the dielectric material 1626 disposed between the interconnect structures 1628 in different ones of the metallization layers 1606-1610 may have different compositions; in other embodiments, the composition of the dielectric material 1626 between different metallization layers 1606-1610 may be the same.

A first metallization layer 1606 may be formed above the device layer 1604. In some embodiments, the first metallization layer 1606 may include lines 1628a and/or vias 1628b, as shown. The lines 1628a of the first metallization layer 1606 may be coupled with contacts (e.g., the S/D contacts 1624) of the device layer 1604. The first metallization layer 1606 may be referred to as the "M0" metallization layer. In some embodiments, the M0 metallization layer may include any suitable portion of any of the microelectronic structures 100 disclosed herein.

A second metallization layer 1608 may be formed above the first metallization layer 1606. In some embodiments, the second metallization layer 1608 may include vias 1628b to couple the lines 1628a of the second metallization layer 1608 with the lines 1628a of the first metallization layer 1606. Although the lines 1628a and the vias 1628b are structurally delineated with a line within each metallization layer (e.g., within the second metallization layer 1608) for the sake of clarity, the lines 1628a and the vias 1628b may be structurally and/or materially contiguous (e.g., simultaneously filled during a dual-damascene process) in some embodiments. The second metallization layer 1608 may be referred to as the "M1" metallization layer. In some embodiments, the M1 metallization layer may include any suitable portion of any of the microelectronic structures 100 disclosed herein.

A third metallization layer 1610 (and additional metallization layers, as desired) may be formed in succession on the second metallization layer 1608 according to similar techniques and configurations described in connection with the second metallization layer 1608 or the first metallization layer 1606. The third metallization layer 1610 may be referred to as the "M2" metallization layer. In some embodiments, the M2 metallization layer may include any suitable portion of any of the microelectronic structures 100 disclosed herein. In some embodiments, the metallization layers that are "higher up" in the metallization stack 1619 in the microelectronic device 1600 (i.e., farther away from the device layer 1604) may be thicker.

The microelectronic device 1600 may include a solder resist material 1634 (e.g., polyimide or similar material) and one or more conductive contacts 1636 formed on the metallization layers 1606-1610. In FIG. 10, the conductive contacts 1636 are illustrated as taking the form of bond pads. The conductive contacts 1636 may be electrically coupled with the interconnect structures 1628 and configured to route the electrical signals of the transistor(s) 1640 to other external devices. For example, solder bonds may be formed on the one or more conductive contacts 1636 to mechanically and/or electrically couple a chip including the microelectronic device 1600 with another component (e.g., a circuit board). The microelectronic device 1600 may include additional or alternate structures to route the electrical signals from the metallization layers 1606-1610; for example, the conductive contacts 1636 may include other analogous features (e.g., posts) that route the electrical signals to external components.

FIG. 11 is a side, cross-sectional view of an example microelectronic package 1650 that may include one or more microelectronic structures 100 in accordance with any of the embodiments disclosed herein. In some embodiments, the microelectronic package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674. These conductive pathways may take the form of any of the interconnect structures 1628 discussed above with reference to FIG. 10.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to other devices included in the package substrate 1652, not shown).

The microelectronic package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 11 are solder bumps, but any suitable first-level interconnects 1665 may be used. In some embodiments, no interposer 1657 may be included in the microelectronic package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., (e.g., a silicon bridge, an organic bridge, one or more waveguides, one or more interposers, wirebonds, etc.).

The microelectronic package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 11 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 11 are solder balls (e.g., for a ball grid array arrangement), but any suitable second-level interconnects 16770 may be used (e.g., pins in a pin grid array arrangement or lands in a land grid array arrangement). The second-level interconnects 1670 may be used to couple the microelectronic package 1650 to another component, such as a circuit board (e.g., a motherboard), an interposer, or another microelectronic package, as known in the art and as discussed below with reference to FIG. 12.

The dies 1656 may take the form of any of the embodiments of the die 1502 discussed herein (e.g., may include any of the embodiments of the microelectronic device 1600). In embodiments in which the microelectronic package 1650 includes multiple dies 1656, the microelectronic package 1650 may be referred to as a multi-chip package (MCP). The dies 1656 may include circuitry to perform any desired functionality. For example, one or more of the dies 1656 may be logic dies (e.g., silicon-based dies), and one or more of the dies 1656 may be memory dies (e.g., high bandwidth memory).

Although the microelectronic package 1650 illustrated in FIG. 11 is a flip chip package, other package architectures may be used. For example, the microelectronic package 1650 may be a ball grid array (BGA) package, such as an embedded wafer-level ball grid array (eWLB) package. In another example, the microelectronic package 1650 may be a wafer-level chip scale package (WLCSP) or a panel fanout (FO) package. Although two dies 1656 are illustrated in the microelectronic package 1650 of FIG. 11, a microelectronic package 1650 may include any desired number of dies 1656. A microelectronic package 1650 may include additional passive components, such as surface-mount resistors, capacitors, and inductors disposed on the first face 1672 or the second face 1674 of the package substrate 1652, or on either face of the interposer 1657. More generally, a microelectronic package 1650 may include any other active or passive components known in the art.

FIG. 12 is a side, cross-sectional view of a microelectronic device assembly 1700 that may include one or more microelectronic packages or otherelectronic components (e.g., a die) including one or more microelectronic structures 100 in accordance with any of the embodiments disclosed herein. The microelectronic device assembly 1700 includes a number of components disposed on a circuit board 1702 (which may be, e.g., a motherboard). The microelectronic device assembly 1700 includes components disposed on a first face 1740 of the circuit board 1702 and an opposing second face 1742 of the circuit board 1702; generally, components may be disposed on one or both faces 1740 and 1742. Any of the microelectronic packages discussed below with reference to the microelectronic device assembly 1700 may take the form of any of the embodiments of the microelectronic package 1650 discussed above with reference to FIG. 11 (e.g., may include one or more microelectronic structures 100 in a die).

In some embodiments, the circuit board 1702 may be a printed circuit board (PCB) including multiple metal layers separated from one another by layers of dielectric material and interconnected by conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The microelectronic device assembly 1700 illustrated in FIG. 12 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 12), male and female portions of a socket, an adhesive, an underfill material, and/or any other suitable electrical and/or mechanical coupling structure.

The package-on-interposer structure 1736 may include a microelectronic package 1720 coupled to a package interposer 1704 by coupling components 1718. The coupling components 1718 may take any suitable form for the application, such as the forms discussed above with reference to the coupling components 1716. Although a single microelectronic package 1720 is shown in FIG. 12, multiple microelectronic packages may be coupled to the package interposer 1704; indeed, additional interposers may be coupled to the package interposer 1704. The package interposer 1704 may provide an intervening substrate used to bridge the circuit board 1702 and the microelectronic package 1720. The microelectronic package 1720 may be or include, for example, a die (the die 1502 of FIG. 9), a microelectronic device (e.g., the microelectronic device 1600 of FIG. 10), or any other suitable component. Generally, the package interposer 1704 may spread a connection to a wider pitch or reroute a connection to a different connection. For example, the package interposer 1704 may couple the microelectronic package 1720 (e.g., a die) to a set of BGA conductive contacts of the coupling components 1716 for coupling to the circuit board 1702. In the embodiment illustrated in FIG. 12, the microelectronic package 1720 and the circuit board 1702 are attached to opposing sides of the package interposer 1704; in other embodiments, the microelectronic package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The microelectronic device assembly 1700 may include a microelectronic package 1724 coupled to the first face 1740 of the circuit board 1702 by coupling components 1722. The coupling components 1722 may take the form of any of the embodiments discussed above with reference to the coupling components 1716, and the microelectronic package 1724 may take the form of any of the embodiments discussed above with reference to the microelectronic package 1720.

The microelectronic device assembly 1700 illustrated in FIG. 12 includes a package-on-package structure 1734 coupled to the second face 1742 of the circuit board 1702 by coupling components 1728. The package-on-package structure 1734 may include a microelectronic package 1726 and a microelectronic package 1732 coupled together by coupling components 1730 such that the microelectronic package 1726 is disposed between the circuit board 1702 and the microelectronic package 1732. The coupling components 1728 and 1730 may take the form of any of the embodiments of the coupling components 1716 discussed above, and the microelectronic packages 1726 and 1732 may take the form of any of the embodiments of the microelectronic package 1720 discussed above. The package-on-package structure 1734 may be configured in accordance with any of the package-on-package structures known in the art.

FIG. 13 is a block diagram of an example computing device 1800 that may include one or more microelectronic structures 100 in accordance with any of the embodiments disclosed herein. For example, any suitable ones of the components of the computing device 1800 may include one or more of the microelectronic device assemblies 1700, microelectronic packages 1650, microelectronic devices 1600, or dies 1502 disclosed herein. A number of components are illustrated in FIG. 13 as included in the computing device 1800, but any one or more of these components may be omitted or duplicated, as suitable for the application. In some embodiments, some or all of the components included in the computing device 1800 may be attached to one or more motherboards. In some embodiments, some or all of these components are fabricated onto a single system-on-a-chip (SoC) die.

Additionally, in various embodiments, the computing device 1800 may not include one or more of the components illustrated in FIG. 13, but the computing device 1800 may include interface circuitry for coupling to the one or more components. For example, the computing device 1800 may not include a display device 1806, but may include display device interface circuitry (e.g., a connector and driver circuitry) to which a display device 1806 may be coupled. In another set of examples, the computing device 1800 may not include an audio input device 1824 or an audio output device 1808, but may include audio input or output device interface circuitry (e.g., connectors and supporting circuitry) to which an audio input device 1824 or audio output device 1808 may be coupled.

The computing device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The computing device 1800 may include a memory 1804, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random access memory (eDRAM) or spin transfer torque magnetic random access memory (STT-MRAM).

In some embodiments, the computing device 1800 may include a communication chip 1812 (e.g., one or more communication chips). For example, the communication chip 1812 may be configured for managing wireless communications for the transfer of data to and from the computing device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The computing device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The computing device 1800 may include battery/power circuitry 1814. The battery/power circuitry 1814 may include one or more energy storage devices (e.g., batteries or capacitors) and/or circuitry for coupling components of the computing device 1800 to an energy source separate from the computing device 1800 (e.g., AC line power).

The computing device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The computing device 1800 may include an audio output device 1808 (or corresponding interface circuitry, as discussed above). The audio output device 1808 may include any device that generates an audible indicator, such as speakers, headsets, or earbuds.

The computing device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The computing device 1800 may include a GPS device 1818 (or corresponding interface circuitry, as discussed above). The GPS device 1818 may be in communication with a satellite-based system and may receive a location of the computing device 1800, as known in the art.

The computing device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The computing device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 1800 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop computing device, a server computing device or other networked computing component, a vehicle computing device (e.g., a vehicle control unit), a laptop computing device, a printer, a scanner, a monitor, a set-top box, an entertainment control unit, a digital camera, a digital video recorder, or a wearable computing device. In some embodiments, the computing device 1800 may be any other electronic device that processes data.

The following paragraphs provide various examples of the embodiments disclosed herein.
Example 1 is a microelectronic structure, including: a metallization region including a conductive via in contact with a conductive line, wherein the conductive line is in a plane of conductive lines, and a longitudinal axis of the conductive via is not oriented perpendicular to the plane.
Example 2 includes the subject matter of Example 1, and further specifies that the conductive via has a non-circular footprint.
Example 3 includes the subject matter of any of Examples 1-2, and further specifies that the conductive via has an oval footprint.
Example 4 includes the subject matter of any of Examples 1-3, and further specifies that an angle of the longitudinal axis of the conductive via is between 40 degrees and 90 degrees.
Example 5 includes the subject matter of any of Examples 1-4, and further specifies that an angle of the longitudinal axis of the conductive via is between 40 degrees and 85 degrees.
Example 6 includes the subject matter of any of Examples 1-5, and further specifies that an angle of the longitudinal axis of the conductive via is between 40 degrees and 80 degrees.
Example 7 includes the subject matter of any of Examples 1-6, and further specifies that an angle of the longitudinal axis of the conductive via is between 40 degrees and 75 degrees.
Example 8 includes the subject matter of any of Examples 1-7, and further specifies that an angle of the longitudinal axis of the conductive via is between 40 degrees and 70 degrees.
Example 9 includes the subject matter of any of Examples 1-8, and further specifies that an angle of the longitudinal axis of the conductive via is between 40 degrees and 65 degrees.
Example 10 includes the subject matter of any of Examples 1-9, and further specifies that an angle of the longitudinal axis of the conductive via is between 40 degrees and 60 degrees.
Example 11 includes the subject matter of any of Examples 1-10, and further specifies that an angle of the longitudinal axis of the conductive via is between 40 degrees and 55 degrees.
Example 12 includes the subject matter of any of Examples 1-11, and further specifies that an angle of the longitudinal axis of the conductive via is between 40 degrees and 50 degrees.
Example 13 includes the subject matter of any of Examples 1-12, and further specifies that an angle of the longitudinal axis of the conductive via is between 40 degrees and 45 degrees.
Example 14 includes the subject matter of any of Examples 1-13, and further specifies that the conductive via is a first conductive via, the conductive line is a first conductive line, the metallization region further includes a second conductive via in contact with a second conductive line in the plane of conductive lines, and a longitudinal axis of the second conductive via is not oriented perpendicular to the plane.
Example 15 includes the subject matter of Example 14, and further specifies that the second conductive via has a non-circular footprint.
Example 16 includes the subject matter of any of Examples 14-15, and further specifies that the second conductive via has an oval footprint.
Example 17 includes the subject matter of any of Examples 14-16, and further specifies that an angle of the longitudinal axis of the second conductive via is between 40 degrees and 90 degrees.
Example 18 includes the subject matter of any of Examples 14-17, and further specifies that an angle of the longitudinal axis of the second conductive via is between 40 degrees and 85 degrees.
Example 19 includes the subject matter of any of Examples 14-18, and further specifies that an angle of the longitudinal axis of the second conductive via is between 40 degrees and 80 degrees.
Example 20 includes the subject matter of any of Examples 14-19, and further specifies that an angle of the longitudinal axis of the second conductive via is between 40 degrees and 75 degrees.
Example 21 includes the subject matter of any of Examples 14-20, and further specifies that an angle of the longitudinal axis of the second conductive via is between 40 degrees and 70 degrees.
Example 22 includes the subject matter of any of Examples 14-21, and further specifies that an angle of the longitudinal axis of the second conductive via is between 40 degrees and 65 degrees.
Example 23 includes the subject matter of any of Examples 14-22, and further specifies that an angle of the longitudinal axis of the second conductive via is between 40 degrees and 60 degrees.
Example 24 includes the subject matter of any of Examples 14-23, and further specifies that an angle of the longitudinal axis of the second conductive via is between 40 degrees and 55 degrees.
Example 25 includes the subject matter of any of Examples 14-24, and further specifies that an angle of the longitudinal axis of the second conductive via is between 40 degrees and 50 degrees.
Example 26 includes the subject matter of any of Examples 14-25, and further specifies that an angle of the longitudinal axis of the second conductive via is between 40 degrees and 45 degrees.
Example 27 includes the subject matter of any of Examples 1-26, and further specifies that the angle of the longitudinal axis of the first conductive via is different than the angle of the longitudinal axis of the second conductive via.
Example 28 includes the subject matter of any of Examples 1-27, and further specifies that a center of a top surface of the conductive via is laterally offset from a center of a top surface of the conductive line in a cross-section taken perpendicular to a longitudinal axis of the conductive line.
Example 29 includes the subject matter of any of Examples 1-28, and further specifies that the metallization region is an M0 metallization layer.
Example 30 includes the subject matter of any of Examples 1-29, and further includes: a device layer; and metallization layers, wherein the metallization region is between the device layer and the metallization layers.
Example 31 is a microelectronic structure, including: a metallization region including a conductive via in contact with a conductive line, wherein a center of a top surface of the conductive via is laterally offset from a center of a bottom surface of the conductive via.
Example 32 includes the subject matter of Example 31, and further specifies that the conductive via has a non-circular footprint.
Example 33 includes the subject matter of any of Examples 31-32, and further specifies that the conductive via has an oval footprint.
Example 34 includes the subject matter of any of Examples 31-33, and further specifies that the conductive line is in a plane of conductive lines, and an angle of the conductive via relative to the plane is between 40 degrees and 90 degrees.
Example 35 includes the subject matter of any of Examples 31-34, and further specifies that the conductive line is in a plane of conductive lines, and an angle of the conductive via relative to the plane is between 40 degrees and 85 degrees.
Example 36 includes the subject matter of any of Examples 31-35, and further specifies that the conductive line is in a plane of conductive lines, and an angle of the conductive via relative to the plane is between 40 degrees and 80 degrees.
Example 37 includes the subject matter of any of Examples 31-36, and further specifies that the conductive line is in a plane of conductive lines, and an angle of the conductive via relative to the plane is between 40 degrees and 75 degrees.
Example 38 includes the subject matter of any of Examples 31-37, and further specifies that the conductive line is in a plane of conductive lines, and an angle of the conductive via relative to the plane is between 40 degrees and 70 degrees.
Example 39 includes the subject matter of any of Examples 31-38, and further specifies that the conductive line is in a plane of conductive lines, and an angle of the conductive via relative to the plane is between 40 degrees and 65 degrees.
Example 40 includes the subject matter of any of Examples 31-39, and further specifies that the conductive line is in a plane of conductive lines, and an angle of the conductive via relative to the plane is between 40 degrees and 60 degrees.
Example 41 includes the subject matter of any of Examples 31-40, and further specifies that the conductive line is in a plane of conductive lines, and an angle of the conductive via relative to the plane is between 40 degrees and 55 degrees.
Example 42 includes the subject matter of any of Examples 31-41, and further specifies that the conductive line is in a plane of conductive lines, and an angle of the conductive via relative to the plane is between 40 degrees and 50 degrees.
Example 43 includes the subject matter of any of Examples 31-42, and further specifies that the conductive line is in a plane of conductive lines, and an angle of the conductive via relative to the plane is between 40 degrees and 45 degrees.
Example 44 includes the subject matter of any of Examples 31-43, and further specifies that the conductive via is a first conductive via, the conductive line is a first conductive line, the metallization region further includes a second conductive via in contact with a second conductive line, the first conductive line and the second conductive line are in a plane of conductive lines, and a center of a top surface of the second conductive via is laterally offset from a center of a bottom surface of the second conductive via.
Example 45 includes the subject matter of Example 44, and further specifies that the second conductive via has a non-circular footprint.
Example 46 includes the subject matter of any of Examples 44-45, and further specifies that the second conductive via has an oval footprint.
Example 47 includes the subject matter of any of Examples 44-46, and further specifies that an angle of the second conductive via relative to the plane is between 40 degrees and 90 degrees.
Example 48 includes the subject matter of any of Examples 44-47, and further specifies that an angle of the second conductive via relative to the plane is between 40 degrees and 85 degrees.
Example 49 includes the subject matter of any of Examples 44-48, and further specifies that an angle of the second conductive via relative to the plane is between 40 degrees and 80 degrees.
Example 50 includes the subject matter of any of Examples 44-49, and further specifies that an angle of the second conductive via relative to the plane is between 40 degrees and 75 degrees.
Example 51 includes the subject matter of any of Examples 44-50, and further specifies that an angle of the second conductive via relative to the plane is between 40 degrees and 70 degrees.
Example 52 includes the subject matter of any of Examples 44-51, and further specifies that an angle of the second conductive via relative to the plane is between 40 degrees and 65 degrees.
Example 53 includes the subject matter of any of Examples 44-52, and further specifies that an angle of the second conductive via relative to the plane is between 40 degrees and 60 degrees.
Example 54 includes the subject matter of any of Examples 44-53, and further specifies that an angle of the second conductive via relative to the plane is between 40 degrees and 55 degrees.
Example 55 includes the subject matter of any of Examples 44-54, and further specifies that an angle of the second conductive via relative to the plane is between 40 degrees and 50 degrees.
Example 56 includes the subject matter of any of Examples 44-55, and further specifies that an angle of the second conductive via relative to the plane is between 40 degrees and 45 degrees.
Example 57 includes the subject matter of any of Examples 31-56, and further specifies that the angle of the first conductive via is different than the angle of the second conductive via.
Example 58 includes the subject matter of any of Examples 31-57, and further specifies that a center of a top surface of the conductive via is laterally offset from a center of a top surface of the conductive line in a cross-section taken perpendicular to a longitudinal axis of the conductive line.
Example 59 includes the subject matter of any of Examples 31-58, and further specifies that the metallization region is an M0 metallization layer.
Example 60 includes the subject matter of any of Examples 31-59, and further includes: a device layer; and metallization layers, wherein the metallization region is between the device layer and the metallization layers.
Example 61 is a microelectronic structure, including: a metallization region including a conductive via in contact with a conductive line, wherein the conductive line is in a plane of conductive lines, a center of a top surface of the conductive via is laterally offset from a center of a top surface of the conductive line in a cross-section taken perpendicular to a longitudinal axis of the conductive line, and the conductive via is angled to land on the conductive line.
Example 62 includes the subject matter of Example 61, and further specifies that the conductive via has a non-circular footprint.
Example 63 includes the subject matter of any of Examples 61-62, and further specifies that the conductive via has an oval footprint.
Example 64 includes the subject matter of any of Examples 61-63, and further specifies that an angle of a longitudinal axis of the conductive via relative to the plane is between 40 degrees and 90 degrees.
Example 65 includes the subject matter of any of Examples 61-64, and further specifies that an angle of a longitudinal axis of the conductive via relative to the plane is between 40 degrees and 85 degrees.
Example 66 includes the subject matter of any of Examples 61-65, and further specifies that an angle of a longitudinal axis of the conductive via relative to the plane is between 40 degrees and 80 degrees.
Example 67 includes the subject matter of any of Examples 61-66, and further specifies that an angle of a longitudinal axis of the conductive via relative to the plane is between 40 degrees and 75 degrees.
Example 68 includes the subject matter of any of Examples 61-67, and further specifies that an angle of a longitudinal axis of the conductive via relative to the plane is between 40 degrees and 70 degrees.
Example 69 includes the subject matter of any of Examples 61-68, and further specifies that an angle of a longitudinal axis of the conductive via relative to the plane is between 40 degrees and 65 degrees.
Example 70 includes the subject matter of any of Examples 61-69, and further specifies that an angle of a longitudinal axis of the conductive via relative to the plane is between 40 degrees and 60 degrees.
Example 71 includes the subject matter of any of Examples 61-70, and further specifies that an angle of a longitudinal axis of the conductive via relative to the plane is between 40 degrees and 55 degrees.
Example 72 includes the subject matter of any of Examples 61-71, and further specifies that an angle of a longitudinal axis of the conductive via relative to the plane is between 40 degrees and 50 degrees.
Example 73 includes the subject matter of any of Examples 61-72, and further specifies that an angle of a longitudinal axis of the conductive via relative to the plane is between 40 degrees and 45 degrees.
Example 74 includes the subject matter of any of Examples 61-73, and further specifies that the conductive via is a first conductive via, the conductive line is a first conductive line, the metallization region further includes a second conductive via in contact with a second conductive line, the second conductive line is in the plane of conductive lines, and wherein a center of a top surface of the second conductive via is laterally offset from a center of a top surface of the second conductive line in a cross-section taken perpendicular to a longitudinal axis of the second conductive line, and the second conductive via is angled to land on the second conductive line.
Example 75 includes the subject matter of Example 74, and further specifies that the second conductive via has a non-circular footprint.
Example 76 includes the subject matter of any of Examples 74-75, and further specifies that the second conductive via has an oval footprint.
Example 77 includes the subject matter of any of Examples 74-76, and further specifies that an angle of a longitudinal axis of the second conductive via relative to the plane is between 40 degrees and 90 degrees.
Example 78 includes the subject matter of any of Examples 74-77, and further specifies that an angle of a longitudinal axis of the second conductive via relative to the plane is between 40 degrees and 85 degrees.
Example 79 includes the subject matter of any of Examples 74-78, and further specifies that an angle of a longitudinal axis of the second conductive via relative to the plane is between 40 degrees and 80 degrees.
Example 80 includes the subject matter of any of Examples 74-79, and further specifies that an angle of a longitudinal axis of the second conductive via relative to the plane is between 40 degrees and 75 degrees.
Example 81 includes the subject matter of any of Examples 74-80, and further specifies that an angle of a longitudinal axis of the second conductive via relative to the plane is between 40 degrees and 70 degrees.
Example 82 includes the subject matter of any of Examples 74-81, and further specifies that an angle of a longitudinal axis of the second conductive via relative to the plane is between 40 degrees and 65 degrees.
Example 83 includes the subject matter of any of Examples 74-82, and further specifies that an angle of a longitudinal axis of the second conductive via relative to the plane is between 40 degrees and 60 degrees.
Example 84 includes the subject matter of any of Examples 74-83, and further specifies that an angle of a longitudinal axis of the second conductive via relative to the plane is between 40 degrees and 55 degrees.
Example 85 includes the subject matter of any of Examples 74-84, and further specifies that an angle of a longitudinal axis of the second conductive via relative to the plane is between 40 degrees and 50 degrees.
Example 86 includes the subject matter of any of Examples 74-85, and further specifies that an angle of a longitudinal axis of the second conductive via relative to the plane is between 40 degrees and 45 degrees.
Example 87 includes the subject matter of any of Examples 61-86, and further specifies that the angle of the longitudinal axis of the first conductive via is different than the angle of the longitudinal axis of the second conductive via.
Example 88 includes the subject matter of any of Examples 61-87, and further specifies that a center of a top surface of the conductive via is laterally offset from a center of a top surface of the conductive line in a cross-section taken perpendicular to a longitudinal axis of the conductive line.
Example 89 includes the subject matter of any of Examples 61-88, and further specifies that the metallization region is an M0 metallization layer.
Example 90 includes the subject matter of any of Examples 61-89, and further includes: a device layer; and metallization layers, wherein the metallization region is between the device layer and the metallization layers.
Example 91 is a computing device, including: a die including any of the microelectronic structures of any of Examples 1-90; and a circuit board, wherein the die is communicatively coupled to the circuit board.
Example 92 includes the subject matter of Example 91, and further specifies that the die is included in a package, and the package is communicatively coupled to the circuit board.
Example 93 includes the subject matter of Example 92, and further specifies that the package is communicatively coupled to the circuit board by solder.
Example 94 includes the subject matter of any of Examples 91-93, and further specifies that the circuit board is a motherboard.
Example 95 includes the subject matter of any of Examples 91-94, and further specifies that the die is part of a processing device or a memory device.
Example 96 includes the subject matter of any of Examples 91-95, and further specifies that the computing device is a mobile computing device.
Example 97 includes the subject matter of any of Examples 91-95, and further specifies that the computing device is a laptop computing device.
Example 98 includes the subject matter of any of Examples 91-95, and further specifies that the computing device is a desktop computing device.
Example 99 includes the subject matter of any of Examples 91-95, and further specifies that the computing device is a wearable computing device.
Example 100 includes the subject matter of any of Examples 91-95, and further specifies that the computing device is a server computing device.
Example 101 includes the subject matter of any of Examples 91-95, and further specifies that the computing device is a vehicle computing device.
Example 102 includes the subject matter of any of Examples 91-101, and further specifies that the computing device further includes a display communicatively coupled to the circuit board.
Example 103 includes the subject matter of any of Examples 91-102, and further specifies that the computing device further includes an antenna communicatively coupled to the circuit board.
Example 104 includes the subject matter of any of Examples 91-103, and further specifies that the computing device further includes a housing around the die and the circuit board.
Example 105 includes the subject matter of Example 104, and further specifies that the housing includes a plastic material.
Example 106 includes any of the manufacturing methods disclosed herein.

## Claims

1. A microelectronic structure, comprising:
a metallization region including a conductive via in contact with a conductive line, wherein the conductive line is in a plane of conductive lines, and a longitudinal axis of the conductive via is not oriented perpendicular to the plane.

2. The microelectronic structure of claim 1, wherein the conductive via has a non-circular footprint.

3. The microelectronic structure of any of claims 1-2, wherein the conductive via has an oval footprint.

4. The microelectronic structure of any of claims 1-3, wherein an angle of the longitudinal axis of the conductive via is between 40 degrees and 90 degrees.

5. The microelectronic structure of any of claims 1-4, wherein the conductive via is a first conductive via, the conductive line is a first conductive line, the metallization region further includes a second conductive via in contact with a second conductive line in the plane of conductive lines, and a longitudinal axis of the second conductive via is not oriented perpendicular to the plane.

6. The microelectronic structure of claim 5, wherein the second conductive via has a non-circular footprint.

7. The microelectronic structure of any of claims 5-6, wherein the second conductive via has an oval footprint.

8. The microelectronic structure of any of claims 5-7, wherein an angle of the longitudinal axis of the second conductive via is between 40 degrees and 90 degrees.

9. The microelectronic structure of any of claims 5-8, wherein an angle of the longitudinal axis of the second conductive via is between 40 degrees and 70 degrees.

10. The microelectronic structure of any of claims 5-9, wherein an angle of the longitudinal axis of the second conductive via is between 40 degrees and 55 degrees.

11. The microelectronic structure of any of claims 5-10, wherein an angle of the longitudinal axis of the second conductive via is between 40 degrees and 45 degrees.

12. The microelectronic structure of any of claims 5-11, wherein an angle of the longitudinal axis of the first conductive via is different than an angle of the longitudinal axis of the second conductive via.

13. The microelectronic structure of any of claims 1-12, wherein a center of a top surface of the conductive via is laterally offset from a center of a top surface of the conductive line in a cross-section taken perpendicular to a longitudinal axis of the conductive line.

14. The microelectronic structure of any of claims 1-13, wherein the metallization region is an M0 metallization layer.

15. The microelectronic structure of any of claims 1-14, further comprising:
a device layer; and
metallization layers, wherein the metallization region is between the device layer and the metallization layers.
